# EUROPÄISCHE PATENTSCHRIFT

(11) **EP 1 561 281 B1**
(45) Veröffentlichungstag und Bekanntmachung des Hinweises auf die Patenterteilung: **03.12.2008**
(21) Anmeldenummer: 03788984.7
(22) Anmeldetag: 30.10.2003
(51) Int. Cl.: H03M 7/00, G11B 27/10

(54) **VERFAHREN ZUR ERZEUGUNG EINES BITSTROMS AUS EINEM INDIZIERUNGSBAUM**
METHOD FOR THE CREATION OF A BIT STREAM FROM AN INDEXING TREE
PROCEDE DE PRODUCTION D'UN TRAIN DE BITS A PARTIR D'UN ARBRE D'INDEXATION

(30) Priorität: 15.11.2002 DE 10253275; 18.08.2003 DE 10337825
(43) Veröffentlichungstag der Anmeldung: 10.08.2005
(73) Patentinhaber: SIEMENS AKTIENGESELLSCHAFT, 80333 München (DE)
(72) Erfinder: KOSCH, Harald, A-9020 Klagenfurt (AT); HEUER, Jörg, 82041 Oberhaching (DE); HUTTER, Andreas, 81673 München (DE); KOFLER-VOGT, Andrea, 83059 Kolbermoor (DE)
(86) Internationale Anmeldenummer: PCT/EP2003/012098
(87) Internationale Veröffentlichungsnummer: WO 2004/047304

(56) Entgegenhaltungen:
- LAM S W ET AL: "REPRESENTING LEXICONS BY MODIFIED TRIE FOR FAST PARTIAL STRING MATCHING" CHARACTER RECOGNITION TECHNOLOGIES. SAN JOSE, FEB. 1 - 2, 1993, BELLINGHAM, SPIE, US, 1993, Seiten 229-237, XP000628870 ISBN: 0-8194-1139-6
- WONG R K ET AL: "An XML repository for molecular sequence data" PROCEEDINGS IEEE INTERNATIONAL SYMPOSIUM ON BIO-INFORMATICS AND BIOMEDICAL ENGINEERING, 8. November 2000 (2000-11-08), Seiten 35-42, XP010526449
- "TEXT OF ISO/IEC FCD 15938-1 INFORMATION TECHNOLOGY - MULTIMEDIA CONTENT DESCRIPTION INTERFACE - PART 1 SYSTEMS" ISO/IEC JTC1/SC29/WG11 MPEG01/N4001, XX, XX, März 2001 (2001-03), Seiten 1-2,I-V,6-58, XP001001465
- NIEDENNEIER U ET AL: "An MPEG-7 tool for compression and streaming of XML data" PROCEEDINGS OF IEEE INTERNATIONAL CONFERENCE ON MULTIMEDIA AND EXPO (ICME), Bd. 1, 26. August 2002 (2002-08-26), Seiten 521-524, XP010604420

## Beschreibung

Die vorliegende Erfindung betrifft ein Verfahren zur Erzeugung eines Bitstroms aus einem Indizierungsbaum sowie ein Codierverfahren und ein Decodierverfahren, welche von dem Verfahren zur Erzeugung des Bitstroms Gebrauch machen. Ferner betrifft die Erfindung eine Codier- und Decodiervorrichtung.

Es ist häufig erforderlich, bestimmte Inhalte aus einem Bitstrom entsprechend einer von einem Benutzer vorab getroffenen Abfrage auszulesen bzw. hinsichtlich bestimmter Inhalte zu ermitteln, ob diese Inhalte in dem Bitstrom überhaupt enthalten sind. Eine von einem Benutzer definierte Abfrage kann hierbei mittels einer Abfragesprache, wie SQL (siehe Referenz [1]) oder XPATH (siehe Referenz [2]) formuliert werden. Es ist hierbei vorteilhaft, wenn nicht der gesamte Bitstrom nach den gewünschten Inhalten durchsucht werden muss, sondern wenn die Informationen in einer Indizierungsliste oder in einem Indizierungsbaum abgelegt sind, so dass lediglich der Teil des Bitstroms, in dem der Indizierungsbaum bzw. die Indizierungsliste gespeichert sind, durchsucht werden muss.

Das Problem des Auslesens von Daten aus einem Bitstrom ergibt sich beispielsweise bei einem mit Hilfe der XML-Sprache (XML = extensible markup language) erstellten Dokument, das im MPEG7-BiM Format repräsentiert wird. Bezüglich des MPEG7-BiM Formats eines XML-Dokuments sei hierbei insbesondere auf das Dokument [3] verwiesen. Bei einer derartigen Repräsentation wird der erzeugte Bitstrom in mehrere Einheiten (access units) aufgeteilt, welche ihrerseits wiederum aus mehreren Fragmenten (fragment update units) bestehen. Die Einheiten werden codiert und bei Bedarf als MPEG7-BiM-Strom an einen oder mehrere Empfänger versandt.

In Bezug auf die Abfrage von Informationen aus XML-Dokumenten sind bereits eine Vielzahl von Abfragesprachen bekannt, die es erlauben, nach bestimmten Informationen in dem Dokument zu suchen. Beispielhaft sei an dieser Stelle auf die bereits erwähnte Abfragesprache XPATH (siehe Referenz [2]) verwiesen. Mit der Abfragesprache XPATH können Auswahlkriterien zur Filterung gewünschter Informationen innerhalb eines XML Dokuments definiert werden. Ziel einer Abfrage kann hierbei einerseits die Bewertung sein, ob eine Einheit des Bitstroms für den Empfänger wichtig ist. Andererseits kann mit Hilfe einer Abfrage gezielt auf gewünschte Informationen in dem XML-Dokument zurückgegriffen werden. Das MPEG7-Codierverfahren hat bis jetzt bei der Erzeugung des Bitstroms eines XML-Dokuments keine Mechanismen vorgesehen, die einen wahlfreien Zugriff auf bestimmte Elemente des XML-Dokuments ermöglichen. Der MPEG7-Bitstrom muss deshalb zur Suche nach Elementen decodiert werden. Man erhält dann wieder ein Dokument im XML-Format, welches mittels der Abfragesprache XPATH durchsucht werden kann. Das Decodieren und anschließende Abarbeiten eines XML-Dokuments zur Suche nach spezifischen Inhalten ist somit sehr zeitaufwendig und für bestimmte zeitkritische Anwendungen unakzeptabel. Ferner kann das Problem auftreten, dass der Speicher im Decoder begrenzt ist, so dass der Bitstrom nicht vollständig decodiert wird. Darüber hinaus war der Aufwand des Decodierens unnötig, falls die am decodierten XML-Dokument durchgeführte XPATH-Abfrage negativ verläuft.

Im Rahmen von TV-Anytime (TVA), das in Dokument [4] beschrieben ist, wird eine Indexstruktur verwendet, die einen wahlfreien Zugriff auf bestimmte Elemente eines Datenfragmentes erlaubt. Die Indexstruktur besteht aus mehreren Teilen und umfasst eine sog. Key-Index-Liste, in der sämtliche indizierte Pfade eines Dokumentes abgelegt werden. Bei einer Abfrage werden diese Pfade der Reihe nach mit der Abfrage verglichen, bis ein entsprechender Eintrag in der Key-Index-Liste gefunden wird. Durch die Informationen, die in der Key-Index-Liste zu diesem Eintrag gespeichert sind, können die Stellen in einem Beschreibungsstrom bestimmt werden, an denen der indizierte Eintrag codiert vorliegt. Durch die Verwendung der Key-Index-Liste ist es nicht mehr erforderlich, uninteressante Datenfragmente zu decodieren, so dass weniger Speicherplatz während einer Abfrage benötigt wird. Das lineare Durchwandern der Key-Index-Liste ist aber zeitkonsumierend und die Übertragung aller indizierter Pfade ist aufwendig.

Das Dokument Lam S. W. et al., "Representing lexicons by modified trie for fast partial string matching", Character Recognition Technologies, San Jose, 1-2 Feb. 1993, Bellingham, SPIE, Seiten 229-237, beschreibt ein schnelles lexikalisches Suchverfahren, bei dem eine Eingangssequenz sowohl eine unklare Länge als auch einige nicht-spezifizierte Buchstaben umfassen kann.

Das Dokument Wong R. K. et al., "An XML repository for molecular sequence data", Proceedings IEEE International Symposium on Bio Informatics and Biomedical Engineering", Seiten 35-42, beschreibt ein Verfahren, bei dem mit Hilfe eines "Skip-Tree" eine große Datenmenge effizient durchsucht werden kann.

Aufgabe der Erfindung ist es deshalb, ein Verfahren zur Erzeugung eines Bitstroms aus einem Indizierungsbaum zu schaffen, bei dem die Suche nach indizierten Daten einfach und effizient ermöglicht wird.

Diese Aufgabe wird gemäß den Merkmalen der unabhängigen Patentansprüche gelöst. Weiterbildungen der Erfindung ergeben sich aus den abhängigen Ansprüchen.

Der Indizierungsbaum, aus dem mit dem erfindungsgemäßen Verfahren ein Bitstrom erzeugt wird, umfasst eine Mehrzahl von Hierarchieebenen, wobei jeder Hierarchieebene ein oder mehrere Indexknoten zugeordnet sind und die Indexknoten Indexdaten enthalten, die in dem Indizierungsbaum nach einem oder mehreren vorgegebenen Kriterien sortiert sind. Bei dem erfindungsgemäßen Verfahren werden die Indexdaten der Indexknoten in den Bitstrom eingefügt und ferner wird für einen Indexknoten jeweils die Information in den Bitstrom eingefügt, an welcher Stelle im Bitstrom sich die Indexdaten von einem oder mehreren Indexknoten der Hierarchieebene, die unterhalb der Hierarchieebene des jeweiligen Knotens liegt, befinden. Durch die Speicherung der zusätzlichen Information bezüglich der Indexknoten in einer darunter liegenden Hierarchieebene wird eine Suche nach bestimmten Indexdaten wesentlich vereinfacht, da hierdurch Sprünge zu den für die Suche relevanten Indexknoten ermöglicht werden. Somit wird eine wesentlich effizientere Abfrage und Suche nach Indexdaten gewährleistet.

In einer bevorzugten Ausführungsform ist der Indizierungsbaum als sog. B-Tree (= Balanced Tree) aufgebaut, der eine ausgeglichene Verteilung der Daten auf die Knoten des Baums gewährleistet. Eine genaue Beschreibung des B-Trees findet sich in der Referenz [5].

Die Indexdaten in dem Indizierungsbaum können nach beliebigen Kriterien sortiert sein, beispielsweise lexikographisch.

In einer besonders bevorzugten Ausführungsform sind die Indexdaten nach der Depth-First-Ordnung in den Bitstrom eingefügt. Durch die Verwendung der Depth-First-Ordnung werden die Indexdaten in dem Indizierungsbaum zunächst der Tiefe nach in den Bitstrom eingefügt, wodurch die für eine Abfrage relevanten Informationen im Bitstrom benachbart zueinander angeordnet werden und nicht relevante Informationen effizient übersprungen werden können. Eine genaue Beschreibung der Depth-First-Ordnung findet sich in der Referenz [6].

In einer weiteren bevorzugten Ausführungsform der Erfindung umfassen die Indexdaten Pfade eines Dokumentenstrukturbaums, der einen Wurzelknoten und eine Mehrzahl von Blattknoten umfasst. Ferner umfassen die Indexdaten vorzugsweise die Werteausprägungen der Pfade und die Positionen der Werteausprägungen in dem Dokument, das durch den Dokumentenstrukturbaum dargestellt ist. Darüber hinaus umfassen die Indexdaten in einer bevorzugten Ausführungsform auch noch die Anzahl der Pfade in einem Indexknoten.

Die Pfade können hierbei Absolutpfade sein, die von dem Wurzelknoten des Dokumentenstrukturbaums beginnen und zu einem Blattknoten des Dokumentenstrukturbaums führen. In einer besonders bevorzugten Ausführungsform der Erfindung sind die Pfade jedoch relative Pfade, wobei ein relativer Pfad eines jeweiligen Indexknotens ein Pfad relativ zu einem zuvor in den Bitstrom eingefügten Pfad des jeweiligen Indexknotens oder eines Indexknotens einer über der Hierarchieebene des jeweiligen Indexknotens liegenden Hierarchieebene ist. Durch die Verwendung von relativen Pfaden werden Gemeinsamkeiten in den Pfaden ausgenutzt, denn die Pfade von benachbarten Knoten haben meist einen gemeinsamen Anteil. Auf diese Weise kann der benötigte Speicherbedarf für die Indexdaten im Bitstrom reduziert werden. Eine weitere Reduzierung des Speicherbedarfs kann dadurch erreicht werden, dass die Pfade des Indexknotens, dessen Indexdaten als erste einer Hierarchieebene in den Bitstrom eingefügt werden, in einer Reihenfolge umgekehrt zu der Reihenfolge, in der die Indexdaten in dem Indexknoten angeordnet sind, in den Bitstrom eingefügt werden. Hierbei wird die Tatsache berücksichtigt, dass die Indexdaten am Ende des ersten Indexknotens einer Hierarchieebene eine größere Ähnlichkeit zu dem Indexknoten der nächsthöheren Hierarchieebene aufweisen als die Indexdaten am Anfang des ersten Indexknotens. Folglich ergibt sich in bestimmten Fällen eine besonders effektive Codierung mittels von relativen Pfaden.

In einer besonders bevorzugten Ausführungsform der Erfindung umfassen die Pfade Beschreibungselemente eines XML-Dokuments (XML = extensible markup language), wobei die Pfade insbesondere XPATH-Pfade des XML-Dokuments sind.

In einer weiteren Ausführungsform der Erfindung sind die Indexdaten mit einem Codierverfahren binär codiert, insbesondere mit einem MPEG-Codierverfahren. In einer besonders bevorzugten Ausführungsform wird als Codierverfahren das MPEG7-Codierverfahren verwendet.

Neben dem oben beschriebenen Verfahren zur Erzeugung eines Bitstroms umfasst die Erfindung ferner ein Verfahren zum Codieren einer Datenstruktur, bei dem die Datenelemente der Datenstruktur in einem Indizierungsbaum indiziert sind, wobei ein Bitstrom gemäß dem erfindungsgemäßen Verfahren erzeugt wird und dieser Bitstrom Teil des codierten Datenstroms ist. Darüber hinaus umfasst die Erfindung ein Verfahren zum Decodieren einer Datenstruktur, wobei das Verfahren derart ausgestaltet ist, dass eine mit dem soeben beschriebenen Codierverfahren codierte Datenstruktur decodiert wird.

Darüber hinaus umfasst die Erfindung ein Verfahren zum Codieren und Decodieren einer Datenstruktur, welches das oben beschriebene Codierverfahren und Decodierverfahren umfasst.

Die Erfindung umfasst auch eine Codiervorrichtung, mit der das erfindungsgemäße Codierverfahren durchführbar ist, sowie eine Decodiervorrichtung, mit der das erfindungsgemäße Decodierverfahren durchführbar ist. Ferner betrifft die Erfindung eine entsprechende Vorrichtung zum Codieren und Decodieren, mit der das oben beschriebene kombinierte Codier- und Decodierverfahren durchführbar ist.

Ausführungsbeispiele der Erfindung werden nachfolgend anhand der Zeichnungen dargestellt und erläutert.

Es zeigen
- Fig.1: ein Beispiel eines in dem erfindungsgemäßen Verfahren verwendeten Indizierungsbaums;
- Fig.2: einen Ausschnitt aus dem in Fig. 1 gezeigten Indizierungsbaum;
- Fig.3: einen Ausschnitt aus einem Bitstrom, der aus dem Indizierungsbaum der Fig. 1 mit dem erfindungsgemäßen Verfahren generiert wurde;
- Fig.4: einen vereinfachten Indizierungsbaum, in dem die Indexdaten lexikographisch geordnet sind und Pfade eines Dokumentenstrukturbaums darstellen;
- Fig.5: den Indizierungsbaum der Fig. 4, wobei die Pfade der zweiten Hierarchieebene teilweise als relative Pfade dargestellt sind;
- Fig.6: den Indizierungsbaum der Fig. 4, wobei alle Pfade der zweiten Hierarchieebene als relative Pfade dargestellt sind; und
- Fig.7: eine Abwandlung des Indizierungsbaums gemäß Fig. 4.

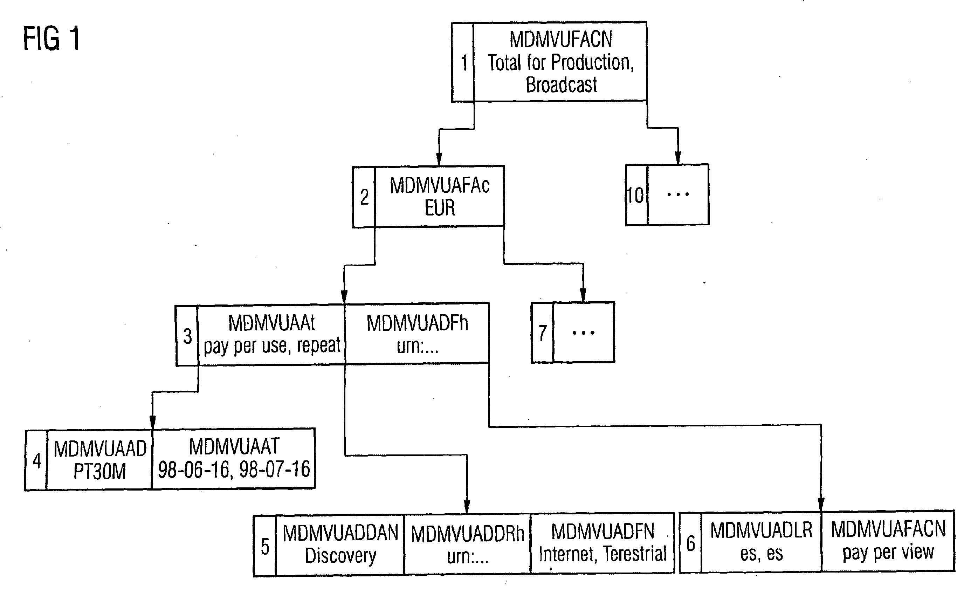

Figur 1 zeigt beispielhaft einen in dem erfindungsgemäßen Verfahren verwendeten Indizierungsbaum. Es handelt sich bei diesem Baum um einen sog. B-Baum (B steht für Balanced), welcher häufig bei der Indizierung von Daten zur Anwendung kommt. Die Struktur eines B-Baums ist beispielsweise in der bereits erwähnten Referenz [5] beschrieben. Der B-Baum weist eine ausgeglichene Struktur auf und ermöglicht hierdurch ein Suchen mit einem gemessen an der Zahl der Einträge nur logarithmischen Aufwand, wohingegen beim Suchen mit einer Liste ein linearer Aufwand erforderlich ist.

Der Indizierungsbaum enthält eine Mehrzahl von Knoten 1 bis 10, wobei in jedem Knoten eine oder mehrere Indexdaten in Form von sog. Schlüsseln gespeichert sind. Im vorliegenden Fall sind die Indexdaten sog. XPATH-Pfade eines Beschreibungsbaums eines XML-Dokuments. Eine Beschreibung von XPATH-Pfaden findet sich in der bereits erwähnten Referenz [2]. Die XPATH-Pfade führen von dem Wurzelknoten des Beschreibungsbaums des XML-Dokuments zu den einzelnen Blattknoten des Beschreibungsbaums des XML-Dokuments. Es werden in dem in dieser Ausführungsform verwendeten Beschreibungsbaum als Blattknoten XML-Elemente mit einfachem Inhalt und alle XML-Attribute verwendet. Folglich umfassen die Indexdaten des in Figur 1 gezeigten Indizierungsbaums Wurzel-Blatt-Pfade eines XML-Beschreibungsbaums.

Die XPATH-Pfade sind in dem Indizierungsbaum der Fig. 1 als eine Reihe aus Groß- und Kleinbuchstaben dargestellt und lexikographisch geordnet, wobei jeder Buchstabe für einen Elementnamen in dem XML-Beschreibungsbaum steht. Beispielsweise bedeutet der Pfad MDMVUFACN in Knoten 1 MPEG7/Description/MultimediaContent/Video/UsageInformation/FinancialResults/AccountItem/Costtype/Name. Neben dem Pfad sind in den Knoten auch die Werteausprägungen gespeichert, in denen dieser Pfad in dem XML-Dokument auftritt. Im vorliegenden Fall tritt der Pfad MDMVUFACN im Indexknoten 1 zweimal mit den Ausprägungen "Total for Production" und "Broadcast" auf. Demgegenüber tritt beispielsweise der Pfad MDMVUAFAc im Indexknoten 2 nur einmal mit der Ausprägung "EUR" auf.

Die Nummerierung der Indexknoten in dem Indizierungsbaum der Figur 1 entspricht der Reihenfolge, in welcher die Indexdaten mit Hilfe des erfindungsgemäßen Verfahrens in den Bitstroms eingefügt werden. Die Reihenfolge entspricht hierbei einer sog. Depth-First-Ordnung, die beispielsweise in der bereits erwähnten Referenz [6] beschrieben ist. Durch das Einfügen der Indexdaten in den Bitstrom gemäß der Depth-First-Ordnung ergibt sich eine geringere Komplexität beim Zugriff auf die Indexdaten, da bei der Suche nach Indexdaten nicht relevante Informationen übersprungen werden.

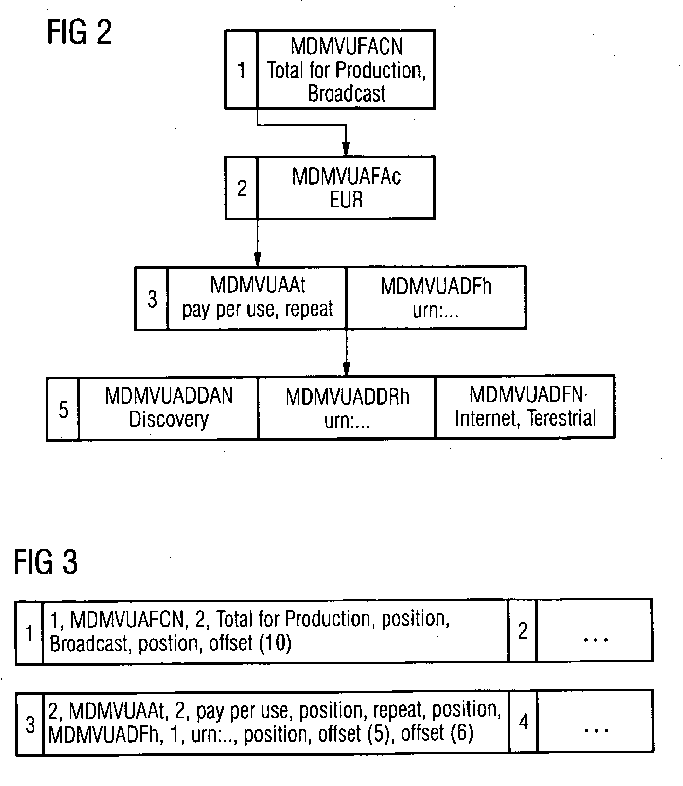

In Figur 2 ist ein Ausschnitt aus dem Indizierungsbaum der Figur 1 gezeigt, an dem an einem Beispiel die Abfrage von Indexdaten in diesem Baum erläutert wird. Es handelt sich hierbei um die Abfrage, ob der XPATH-Pfad MPEG7/Description/Multimediacontent/Video/UsageInformation/Availability/Dissemination/Disseminator/Agent/Name die Werteausprägung "Discovery" enthält (in Kurzschreibweise MDMVUADDAN = "Discovery"). Da der Suchstring MDMVUADDAN lexikographisch kleiner ist als der XPATH-Pfad "MDMVUFACN" des Indexknotens 1 wird auf den Indexknoten 2 zurückgegriffen. Der Suchstring ist wiederum lexikographisch kleiner als der Eintrag "MDMVUAFAc" des Indexknotens 2. Deshalb wird auf den links des Indexknotens 2 gelegenen Indexknoten 3 übergegangen. Dieser Indexknoten enthält zwei XPATH-Pfade "MDMVUAAt" und "MDMVUADFh". Der Suchstring liegt zwischen diesen beiden XPATH-Pfaden, so dass in der nächsten Hierarchieebene auf den zwischen Indexknoten 4 und Indexknoten 6 liegenden Indexknoten 5 übergegangen wird. Dieser Indexknoten enthält nunmehr als erstes Element den gesuchten XPATH-Pfad "MDMVUADDAN" sowie die gesuchte Werteausprägung "Discovery". Es wurde somit in dem Indexknoten 5 die passende Werteausprägung gefunden und man erhält dann die Position des entsprechenden Elementes im indizierten XML-Dokument. Dadurch, dass die Indexknoten in den Bitstrom gemäß der Depth-First-Ordnung eingefügt sind, werden alle weiteren Knoten des Indizierungsbaums bei der Suche ignoriert bzw. übersprungen, so dass die Suche nach Elementen im Indizierungsbaum geringe Komplexität aufweist.

Im folgenden wird detailliert auf die Einfügung der Indexdaten in den Bitstroms mittels des erfindungsgemäßen Verfahrens eingegangen. Dies geschieht anhand der Figur 3, welche einen Ausschnitt aus einem mit dem erfindungsgemäßen Verfahren erzeugten Bitstrom darstellt. In dem in Figur 3 gezeigten Bitstrom sind übersichtshalber die Nummern der Indexknoten aufgeführt, wobei diese Nummern jedoch nicht mit dem Strom übermittelt werden. Im Detail sind in Figur 3 die Inhalte der Indexknoten 1 und 3 gezeigt. Die Knoten enthalten als erstes Element zunächst die Anzahl der Einträge, d.h. die Anzahl der in dem Knoten gespeicherten XPATH-Pfade. Für den Indexknoten 1 ergibt sich hier die Zahl 1 und für den Indexknoten 3 die Zahl 2. Anschließend folgt für jeden Eintrag der Schlüssel, d.h. der jeweilige XPATH-Pfad sowie die Anzahl der Instanziierungen, d.h. die Anzahl der Werteausprägungen, die dieser XPATH-Pfad in dem XML-Dokument hat. Für den Indexknoten 1 ergibt sich beispielsweise für den XPATH-Pfad "MDMVUAFCN" die Instanziierungsanzahl 2, da der Pfad mit den beiden Werteausprägungen "Total for Production" und "Broadcast" in dem XML-Dokument auftritt. Für jede Werteausprägung wird ferner die Position dieser Werteausprägung in dem XML-Dokument in den Bitstrom eingefügt. Es ist bei dem erfindungsgemäßen Verfahren wesentlich, dass neben diesen Informationen ferner in den Bitstrom die Information eingefügt wird, an welcher Position im Bitstrom - insbesondere an welcher Position relativ zur momentanen Position (offset) - sich die Indexdaten von mit dem jeweiligen Indexknoten verbundenen Indexknoten der darunter liegenden Hierarchieebene befinden. Hierdurch wird das Überspringen von Knoten ermöglicht, die für eine vorgegebene Suchabfrage nicht relevant sind.

Im folgenden bezeichnet man die sich von einem Knoten in eine tiefer liegende Hierarchieebene verzweigenden Knoten als Kindknoten. Es ist bei dem erfindungsgemäßen Verfahren zu beachten, dass die Information bezüglich der Position des ersten Kindknotens einer Hierarchieebene nicht gespeichert werden muss, da dieser Kindknoten im Bitstrom als nächster eingelesen wird. Wie der Figur 3 entnommen werden kann, werden somit für den Indexknoten 1 lediglich die Position des Indexknotens 10 (als "offset (10)" bezeichnet) und für den Indexknoten 3 lediglich die Positionen der Indexknoten 5 und 6 (bezeichnet als "offset(5)" und "offset (6)") gespeichert. Ergibt sich beispielsweise, dass die gesuchte Information bei einer Abfrage lexikographisch größer als der XPATH in Knoten 1 ist, wird sofort zum Knoten 10 gesprungen, so dass es nicht mehr notwendig ist, den Indexknoten 2 und die sich von dem Indexknoten 2 verzweigenden Indexknoten zu durchsuchen. Hierdurch wird eine effektive Suche ermöglicht.

In der nachfolgenden Tabelle ist nochmals aufgeführt, welche Informationen pro Knoten in dem Bitstrom gespeichert werden.

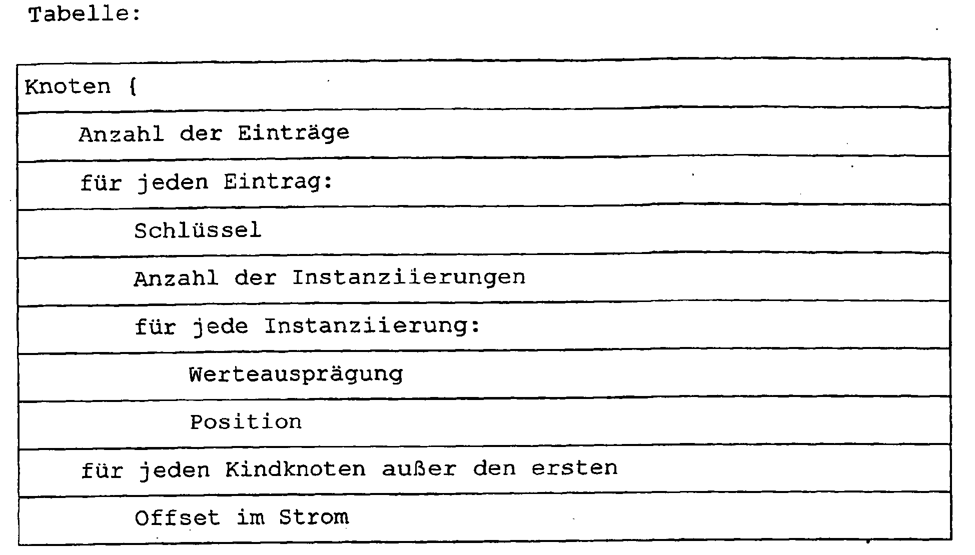

Der mit dem erfindungsgemäßen Verfahren erzeugte Bitstrom wird an den Empfänger übermittelt und kann entsprechend einer Abfrage, die beispielhaft in Bezug auf Figur 2 erläutert wurde, ausgelesen werden. Durch Vergleiche zwischen dem abzufragenden XPATH und den Einträgen in den Indexknoten werden so lange bestimmte Knoteninformationen aus dem Strom ausgelesen, bis der entsprechende gesuchte XPATH mit der gesuchten Werteausprägung gefunden wurde oder bis kein passender XPATH-Pfad aufgrund der Sortierung mehr möglich ist. Im letzteren Fall ist die gewünschte Information im indizierten Dokument nicht enthalten.

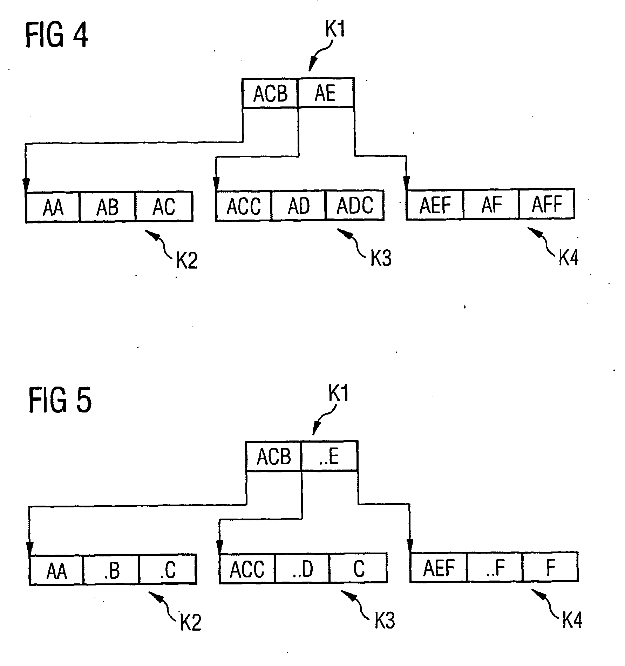

Im folgenden werden anhand der Figuren 4 bis 7, welche vereinfachte Indizierungsbäume mit lexikographisch geordneten Einträge darstellen, weitere Ausführungsformen des erfindungsgemäßen Verfahrens erläutert. In Figur 4 ist ein mittels des erfindungsgemäßen Verfahrens zu codierender Indizierungsbaum gezeigt, der Knoten K1 bis K4 umfasst. Der Knoten K1 wird hierbei als Vaterknoten bezeichnet und die sich aus dem Knoten K1 verzweigenden Knoten K2 bis K4 werden als Kindknoten bezeichnet. Bei den Einträgen handelt es sich um Pfade eines Dokumentenstrukturbaums. Statt im Bitstrom die Pfade mit ihrer gesamten Länge zu übertragen, besteht die Möglichkeit, sog. relative Pfade in dem zu übertragenden Indexknoten abzuspeichern, wobei diese Pfade relativ in Bezug auf einen im vorangegangenen übertragenen Pfad des Vaterknotens bzw. in Bezug auf einen im vorangegangenen übertragenen Pfad des momentan zu übertragenden Indexknotens sind.

Die Einfügung von relativen Pfaden in den Bitstrom ist in Figur 5 verdeutlicht. Hierbei bedeutet die Darstellung "." einen Schritt zurück in dem Pfad, auf den sich der relative Pfad bezieht. In dem Knoten K1 wird für den Eintrag "AE" der relative Pfad "..E" in Bezug auf den vorangegangenen Eintrag ACB übertragen. In den Kindknoten K1, K2 und K3 werden jeweils in den zweiten und dritten Einträgen die relativen Pfade in Bezug auf den ersten Pfad des jeweiligen Kindknotens übertragen.

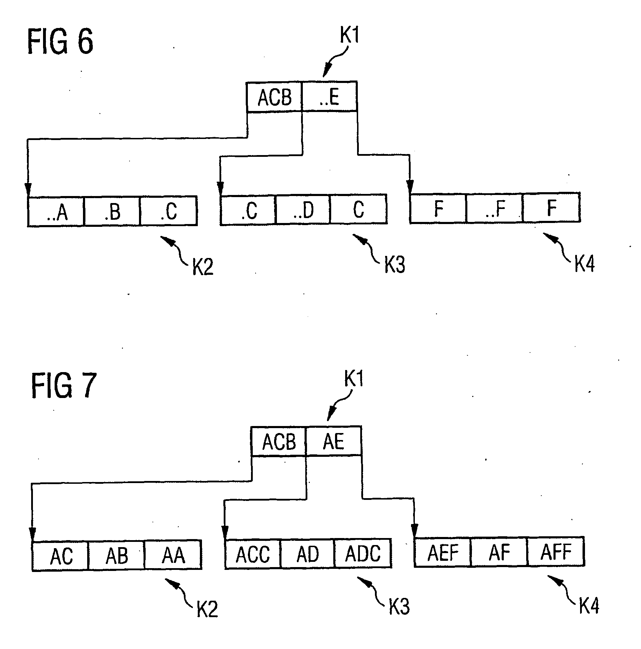

Bei der Ausführungsform der Figur 5 wird für die ersten Pfade AA, ACC bzw. AEF der Kindknoten K2, K3 bzw. K4 der komplette absolute Pfad übertragen. Es ist nun zusätzlich möglich, auch die ersten Pfade der Kindknoten als relative Pfade in Bezug auf einen Pfad des Vaterknotens K1 zu übertragen. Dies ist in Figur 6 dargestellt. Anstatt der Pfade AA und ACC der ersten und zweiten Kindknoten werden hierbei die relativen Pfade "..A" und ".C" in bezug auf den ersten Pfad des Vaterknotens übertragen. Anstatt des Pfads "AEF" des dritten Kindknotens wird der relative Pfad "F" in bezug auf den zweiten Pfad des Vaterknotens übertragen. Die Pfade werden hierbei vorzugsweise in ihrer Bytedarstellung in den Bitstrom abgelegt.

Durch die Verwendung von relativen Pfaden wird das Datenvolumen im Strom stark verringert, da bei der Abspeicherung der Pfade Gemeinsamkeiten in den Pfaden ausgenutzt werden, so dass weniger Speicherplatz benötigt wird. Insbesondere müssen bei relativen Pfaden die jeweiligen gemeinsamen Anteile der Pfade nur einmal übermittelt werden.

In einer weiteren Ausführungsform der Erfindung wird eine Datenersparnis dadurch erreicht, dass bei der Anordnung der Einträge der Indexknoten für den ersten Kindknoten K2 eine gegenüber der Figur 4 umgekehrte Reihenfolge verwendet wird. Hierdurch wird erreicht, dass der Eintrag, der die größte Ähnlichkeit zu dem vorangegangenen Vaterknoten K1 aufweist, am Anfang des Kindknotens K2 steht. Damit können sich bei speziellen Ausgestaltungen des Indizierungsbaums wesentlich verkürzte relative Pfade und ein verringerter Speicherbedarf ergeben.

Die Pfade können die bereits im vorangegangenen erwähnten XPATH-Pfade eines XML-Beschreibungsbaums sein. Ferner können die Pfade binär codiert sein, beispielsweise mit einem MPEG7-Codierverfahren. Insbesondere können die in der bereits erwähnten Referenz [3] spezifizierten Verfahren zur Binärcodierung eingesetzt werden. Der Einsatz von binär codierten Pfaden kann im Vergleich zu textuellen Repräsentationen zu Einsparungen bei der Anzahl der zu übermittelnden Bits führen.

### Literaturverzeichnis:

- [1]: http://dxl.hrz.uni-dortmund.de:8001/doc1/hrz/sqlref/sqloracle.html
- [2]: http://www.w3.org/TR/xpath
- [3]: ISO/IEC 15938-1 Multimedia Content Description Interface - Part 1: Systems, Geneva 2002
- [4]: TV-Anytime Specification Series S-3 on Metadata, Part-B, Version 13
- [5]: http://www.public.asu.edu/∼peterjn/btree/
- [6]: http://www.generation5.org/simple_search.shtml

## Patentansprüche

1. Verfahren zur Erzeugung eines Bitstroms aus einem Indizierungsbaum, wobei
(a) der Indizierungsbaum eine Mehrzahl von Hierarchieebenen umfasst und jeder Hierarchieebene ein oder mehrere Indexknoten (K1, K2, K3, K4) zugeordnet sind,
(b) die Indexknoten (K1, K2, K3, K4) Indexdaten enthalten, die in dem Indizierungsbaum nach einem oder mehreren vorgegebenen Kriterien sortiert sind,
(c) der Indexknoten (K1) als Vaterknoten und die Indexknoten (K2, K3, K4) als Kindknoten bezeichnet werden, wobei sich mindestens ein Kindknoten vom Vaterknoten (K1) verzweigt und dieser Kindknoten sich in einer tiefer liegenden Hierarchieebene befindet,
**dadurch gekennzeichnet, dass**
- die Indexdaten der Indexknoten (K1, K2, K3, K4) in den Bitstrom eingefügt werden, wobei nach Einfügen der Indexdaten des Vaterknotens (K1) die Indexdaten desjenigen Kindknotens (K2) ohne eine Information, an welcher Stelle sich im Bitstrom die Indexdaten dieses Kindknotens (K2) befinden, eingefügt werden, der in dem Indizierungsbaum aufgrund der Sortierung dem Vaterknoten (K1) als erster folgt;
- für den Kindknoten (K3, K4), der dem Vaterknoten (K1) nicht als erstes folgt, jeweils eine Information in den Bitstrom eingefügt wird, an welcher Stelle im Bitstrom sich die Indexdaten dieses Kindknoten (K3, K4) befinden.

2. Verfahren nach Anspruch 1, bei dem der Indizierungsbaum ein B-Tree (= Balanced Tree) ist.

3. Verfahren nach Anspruch 1 oder 2, bei dem die Indexdaten in dem Indizierungsbaum lexikographisch sortiert sind.

4. Verfahren nach einem der vorhergehenden Ansprüche, bei dem die Indexdaten nach der Depth-First-Ordnung in den Bitstrom eingefügt werden.

5. Verfahren nach einem der vorhergehenden Ansprüche, bei dem die Indexdaten Pfade eines Dokumentenstrukturbaums bestehend aus mindestens einen Wurzelknoten und eine Mehrzahl von Blattknoten umfassen.

6. Verfahren nach Anspruch 5, bei dem die Indexdaten die Werteausprägungen der Pfade und die Positionen der Werteausprägungen in dem Dokument, das durch den Dokumentenstrukturbaum dargestellt ist, enthalten.

7. Verfahren nach Anspruch 5 oder 6, bei dem die Indexdaten die Anzahl der Pfade in einem Indexknoten (K1, K2, K3, K4) umfassen.

8. Verfahren nach einem der Ansprüche 5 bis 7, bei dem die Pfade absolute Pfade umfassen, die von dem Wurzelknoten beginnen und zu einem Blattknoten führen.

9. Verfahren nach einem der Ansprüche 5 bis 8, bei dem die Pfade relative Pfade umfassen, wobei ein relativer Pfad eines jeweiligen Indexknotens (K1, K2, K3, K4) ein Pfad relativ zu einem zuvor in den Bitstrom eingefügten Pfad des jeweiligen Indexknotens (K1, K2, K3, K4) oder eines Indexknotens (K1, K2, K3, K4) einer über der Hierarchieebene des jeweiligen Indexknotens (K1, K2, K3, K4) liegenden Hierarchieebene ist.

10. Verfahren nach Anspruch 9, bei dem die Pfade des Indexknotens, dessen Indexdaten als erste einer Hierarchieebene in den Bitstrom eingefügt werden, in einer Reihenfolge umgekehrt zu der Reihenfolge, in der die Indexdaten in dem Indexknoten (K1, K2, K3, K4) angeordnet sind, in den Bitstrom eingefügt werden.

11. Verfahren nach einem der Ansprüche 5 bis 10, bei dem die Pfade Beschreibungselemente eines XML-Dokuments (XML = Extensible Markup Language) umfassen.

12. Verfahren nach Anspruch 11, bei dem die Pfade XPATH-Pfade des XML-Dokuments sind.

13. Verfahren nach einem der vorhergehenden Ansprüche, bei dem die Indexdaten mit einem Codierverfahren binär codiert sind, insbesondere mit einem MPEG-Codierverfahren.

14. Verfahren nach Anspruch 13, bei dem das Codierverfahren ein MPEG7-Codierverfahren ist.

15. Verfahren zum Codieren einer Datenstruktur, bei dem die Datenelemente der Datenstruktur in einem Indizierungsbaum indiziert sind, wobei ein Bitstrom gemäß einem der vorhergehenden Ansprüche erzeugt wird und der Bitstrom Teil des codierten Datenstroms ist.

16. Verfahren zum Decodieren einer Datenstruktur, wobei das Verfahren derart ausgestaltet ist, dass die gemäß Anspruch 15 codierte Datenstruktur anhand der Indexdaten in den Indexknoten decodiert wird.

17. Verfahren zum Codieren und Decodieren einer Datenstruktur, umfassend das Verfahren nach Anspruch 15 und das Verfahren nach Anspruch 16.

18. Codiervorrichtung, mit der ein Verfahren nach Anspruch 15 durchführbar ist.

19. Decodiervorrichtung mit der ein Verfahren nach Anspruch 16 durchführbar ist.

20. Vorrichtung zum Codieren und Decodieren einer Datenstruktur, mit der ein Verfahren nach Anspruch 17 durchführbar ist.

## Claims

1. Method for generating a bit stream from an indexing tree, wherein
(a) the indexing tree comprises a plurality of hierarchy levels and each hierarchy level is assigned one or more index nodes (K1, K2, K3, K4) ,
(b) the index nodes (K1, K2, K3, K4) contain index data which is sorted in the indexing tree according to one or more predetermined criteria,
(c) the index node (K1) is designated as the parent node and the index nodes (K2, K3, K4) are designated as child nodes, with at least one child node branching off from the parent node (K1) and said child node being located in a lower hierarchy level,
**characterized in that**
- the index data of the index nodes (K1, K2, K3, K4) is inserted into the bit stream, whereby, following insertion of the index data of the parent node (K1), the index data of that child node (K2) which follows first after the parent node in the indexing tree on account of the sorting is inserted without information indicating at which position the index data of said child node (K2) is located in the bit stream;
- information is inserted into the bit stream in each case for the child node (K3, K4) which does not follow first after the parent node (K1), said information indicating at which position in the bit stream the index data of said child node (K3, K4) is located.

2. Method according to claim 1, wherein the indexing tree is a B tree (= Balanced tree).

3. Method according to claim 1 or 2, wherein the index data is sorted lexicographically in the indexing tree.

4. Method according to one of the preceding claims, wherein the index data is inserted into the bit stream according to the depth-first ordering principle.

5. Method according to one of the preceding claims, wherein the index data comprises paths of a document structure tree consisting of at least one root node and a plurality of leaf nodes.

6. Method according to claim 5, wherein the index data contains the value instances of the paths and the positions of the value instances in the document which is represented by the document structure tree.

7. Method according to claim 5 or 6, wherein the index data comprises the number of paths in an index node (K1, K2, K3, K4) .

8. Method according to one of the claims 5 to 7, wherein the paths comprise absolute paths which start from the root node and lead to a leaf node.

9. Method according to one of the claims 5 to 8, wherein the paths comprise relative paths, a relative path of a respective index node (K1, K2, K3, K4) being a path relative to a path, previously inserted into the bit stream, of the respective index node (K1, K2, K3, K4) or of an index node (K1, K2, K3, K4) of a hierarchy level above the hierarchy level of the respective index node (K1, K2, K3, K4).

10. Method according to claim 9, wherein the paths inserted into the bit stream are the paths of the index node whose index data is inserted into the bit stream as the first index data of a hierarchy level in a reverse sequence to the sequence in which the index data is arranged in the index node (K1, K2, K3, K4) .

11. Method according to one of the claims 5 to 10, wherein the paths comprise description elements of an XML document (XML = Extensible Markup Language).

12. Method according to claim 11, wherein the paths are XPATH paths of the XML document.

13. Method according to one of the preceding claims, wherein the index data is coded in binary by means of a coding method, in particular by means of an MPEG coding method.

14. Method according to claim 13, wherein the coding method is an MPEG7 coding method.

15. Method for coding a data structure, wherein the data elements of the data structure are indexed in an indexing tree, with a bit stream according to one of the preceding claims being generated and the bit stream being part of the coded data stream.

16. Method for decoding a data structure, wherein the method is embodied in such a way that the data structure coded according to claim 15 is decoded on the basis of the index data in the index nodes.

17. Method for coding and decoding a data structure, comprising the method according to claim 15 and the method according to claim 16.

18. Coding device by means of which a method according to claim 15 can be performed.

19. Decoding device by means of which a method according to claim 16 can be performed.

20. Device for coding and decoding a data structure by means of which a method according to claim 17 can be performed.

## Revendications

1. Procédé pour générer un train de bits à partir d'un arbre d'indexation,
(a) l'arbre d'indexation comprenant une pluralité de niveaux hiérarchiques et un ou plusieurs noeuds d'index (K1, K2, K3, K4) étant affectés à chaque niveau hiérarchique,
(b) les noeuds d'index (K1, K2, K3, K4) contenant des données d'index qui, dans l'arbre d'indexation, sont triées selon un ou plusieurs critères prédéterminés,
(c) le noeud d'index (K1) étant appelé noeud père et les noeuds d'index (K2, K3, K4) , noeuds enfants, au moins un noeud enfant partant du noeud père (K1) et ce noeud enfant se trouvant dans un niveau hiérarchique inférieur,
**caractérisé en ce que**
- les données d'index des noeuds d'index (K1, K2, K3, K4) sont insérées dans le train de bits, les données d'index du noeud enfant (K2), lequel, en raison du tri, vient en premier après le noeud père (K1) dans l'arbre d'indexation, étant insérées après que les données d'index du noeud père (K1) ont été insérées sans information sur la position à laquelle se trouvent les données d'index de ce noeud enfant (K2) dans le train de bits;
- pour le noeud enfant (K3, K4) qui ne vient pas en premier après le noeud père (K1), respectivement une information est insérée dans le train de bits, indiquant à quelle position dans le train de bits se trouvent les données d'index de ce noeud enfant (K3, K4).

2. Procédé selon la revendication 1, dans lequel l'arbre d'indexation est un arbre équilibré (B-Tree, Balanced Tree).

3. Procédé selon la revendication 1 ou 2, dans lequel les données d'index, dans l'arbre d'indexation, sont triées lexicographiquement.

4. Procédé selon l'une des revendications précédentes, dans lequel les données d'index sont insérées dans le train de bits selon l'ordre Depth First.

5. Procédé selon l'une des revendications précédentes, dans lequel les données d'indexation incluent des chemins d'un arbre représentant une structure de document, composé d'au moins un noeud racine et d'une pluralité de noeuds feuilles.

6. Procédé selon la revendication 5, dans lequel les données d'index contiennent les groupes de valeurs des chemins et les positions des groupes de valeurs dans le document qui est représenté par l'arbre représentant une structure de document.

7. Procédé selon la revendication 5 ou 6, dans lequel les données d'index incluent le nombre des chemins dans un noeud d'index (K1, K2, K3, K4) .

8. Procédé selon l'une des revendications 5 à 7, dans lequel les chemins incluent des chemins absolus qui partent du noeud racine et vont vers un noeud feuille.

9. Procédé selon l'une des revendications 5 à 8, dans lequel les chemins incluent des chemins relatifs, un chemin relatif d'un noeud d'index respectif (K1, K2, K3, K4) étant un chemin relativement à un chemin, préalablement inséré dans le train de bits, du noeud d'index respectif (K1, K2, K3, K4) ou d'un noeud d'index (K1, K2, K3, K4) d'un niveau hiérarchique situé au-dessus du niveau hiérarchique du noeud d'index respectif (K1, K2, K3, K4).

10. Procédé selon la revendication 9, dans lequel les chemins du noeud d'index dont les données d'index sont insérées dans le train de bits en tant que les premières d'un niveau hiérarchique sont insérés dans le train de bits dans un ordre inverse de l'ordre dans lequel les données d'index sont disposées dans le noeud d'index (K1, K2, K3, K4).

11. Procédé selon l'une des revendications 5 à 10, dans lequel les chemins incluent des éléments de description d'un document XML (XML = Extensible Markup Language).

12. Procédé selon la revendication 11, dans lequel les chemins sont des chemins XPATH du document XML.

13. Procédé selon l'une des revendications précédentes, dans lequel les données d'index sont codées en binaire avec un procédé de codage, en particulier avec un procédé de codage MPEG.

14. Procédé selon la revendication 13, dans lequel le procédé de codage est un procédé de codage MPEG7.

15. Procédé de codage d'une structure de données, dans lequel les éléments de données de la structure de données sont indexés dans un arbre d'indexation, un train de bits étant généré selon l'une des revendications précédentes et le train de bits faisant partie du flux de données codé.

16. Procédé de décodage d'une structure de données, le procédé étant aménagé de manière telle que la structure de données codée selon la revendication 15 est décodée à l'aide des données d'index dans les noeuds d'index.

17. Procédé de codage et de décodage d'une structure de données incluant le procédé selon la revendication 15 et le procédé selon la revendication 16.

18. Dispositif de codage permettant d'exécuter un procédé selon la revendication 15.

19. Dispositif de décodage permettant d'exécuter un procédé selon la revendication 16.

20. Dispositif de codage et de décodage d'une structure de données permettant d'exécuter un procédé selon la revendication 17.
